(19) Europäisches Patentamt / European Patent Office / Office européen des brevets

(11) **EP 4 357 749 B1**

(12) **EUROPÄISCHE PATENTSCHRIFT**

(45) Veröffentlichungstag und Bekanntmachung des Hinweises auf die Patenterteilung:
**26.02.2025   Patentblatt 2025/09**

(21) Anmeldenummer: **22202382.2**

(22) Anmeldetag: **19.10.2022**

(51) Internationale Patentklassifikation (IPC):
**G01M 13/04** (2019.01)

(52) Gemeinsame Patentklassifikation (CPC):
**G01M 13/021; G01M 13/04**

(54) **VERFAHREN ZUR AUTOMATISCHEN DETEKTION VON VERSCHLEISS, VERZAHNUNGSSCHÄDEN UND/ODER LAGERSCHÄDEN AN EINEM GETRIEBE**

METHOD FOR AUTOMATICALLY DETECTING WEAR, TOOTHING DAMAGE AND/OR BEARING DAMAGE ON A TRANSMISSION

PROCÉDÉ DE DÉTECTION AUTOMATIQUE D'USURE, DE DOMMAGES DE DENTURE ET/OU DE DOMMAGES DE PALIER SUR UNE BOÎTE DE VITESSES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**24.04.2024   Patentblatt 2024/17**

(73) Patentinhaber: **IMS Gear SE & Co. KGaA
78166 Donaueschingen (DE)**

(72) Erfinder:
• **Werschler, Florian
78467 Rottweil (DE)**

• **Katava, Dario
78166 Donaueschingen (DE)**
• **Rehle, Daniel
78078 Niedereschach (DE)**
• **Stöhr, Johannes
78052 Villingen-Schwenningen (DE)**

(74) Vertreter: **Westphal, Mussgnug & Partner
Patentanwälte mbB
Am Riettor 5
78048 Villingen-Schwenningen (DE)**

(56) Entgegenhaltungen:
DE-A1- 102012 022 661       US-B2- 10 203 242
US-B2- 10 379 000           US-B2- 8 180 143

**Beschreibung**

Aufgrund der voranschreitenden Autonomisierung in der Fahrzeug- und der fertigenden Industrie, rückt die automatische Zustandsüberwachung einzelner Bauteile und Baugruppen immer stärker in den Vordergrund.

Insbesondere bei sicherheitsrelevanten Bauteilen und Baugruppen gewinnt eine zusätzliche digitale Rückfallebene immer stärker an Bedeutung. Ein Verfahren zur rechtzeitigen Erkennung vor einer funktionsgefährdenden Beschädigung ist folglich von höchster Wichtigkeit.

Ein solches Verfahren ist bspw. aus der DE 10 2016 222 660 A1 bekannt, bei welchem zum Erkennen von Schäden und/oder Verschleiß an translatorisch bewegten Teilen eines elektromechanischen Antriebs folgende Verfahrensschritte durchgeführt werden:

- Messen des dem elektrischen Antrieb zugeführten elektrischen Stroms,
- Durchführen einer Zeit-Frequenz-Analyse,
- Vergleichen des aus der Zeit-Frequenz-Analyse ermittelten Frequenzspektrums des gemessenen elektrischen Stroms mit einem vorgegebenen Frequenzspektrum, und
- Auslösen eines Fehlersignals, wenn aus dem Vergleich der beiden Frequenzspektren eine Abweichung vorgegebener Größe festgestellt wird.

Des Weiteren beschreibt die US 4 965 513 A ein Verfahren zur Überwachung der Betriebszustände eines elektrisch angetriebenen Ventils, indem eine Analyse des Motorstroms durchgeführt wird. Hierzu werden verschiedene Methoden der Frequenzanalyse auf den Motorstrom angewendet, um eine Rauschsignatur des Motorstroms zu erstellen, mittels welcher Verschleiß und abnormale Betriebszustände erkennbar sein sollen. Anhand der Rauschsignatur sollen unterschiedliche charakteristische Betriebszustände des elektrisch angetriebenen Ventils feststellbar sein, insbesondere könne die Summe aller mechanischen Lastwechsel detektierbar sein, die sich im Frequenzspektrum und den Amplituden manifestieren. Werden solche Rauschsignaturen in unterschiedlichen Zeitabschnitten während des Betriebs erstellt, sollen Alterung und Abnutzung oder abnormale Betriebszustände bestimmbar sein.

Diese aus dem Stand der Technik bekannten Verfahren leiden darunter, dass die Aufbereitung der Motorstromsignale unzureichend ist, um bei variierenden Umwelteinflüssen und/oder Betriebszuständen der Motor-Getriebeeinheit mit einem Elektromotor und einem abtriebsseitig mit demselben verbundenen Getriebe sichere Aussagen bzgl. Verschleiß und Beschädigungen zu treffen. Diese Probleme adressiert der in der EP 4 012 426 A1 beschriebene Ansatz, der aber im Hinblick auf den Ressourceneinsatz und die Frühzeitigkeit der Schadensdetektion noch verbesserungsfähig ist.

Weiterhin offenbart US 8 180 143 B2 ein Verfahren und System zum Bewerten von Kontaktmustern eines Getriebes.

Die Aufgaben der Erfindung bestehen daher darin, ein Verfahren zur automatischen Detektion von Verzahnungsschäden an einem Getriebe bereitzustellen, das eine verbesserte, ressourcensparende und frühzeitige Schadensdetektion, die zugleich weitgehend unabhängig von variierenden Umwelteinflüssen und/oder Betriebszuständen der Motor-Getriebeeinheit ist, ermöglicht.

Bei dem erfindungsgemäßen und in Anspruch 1 definierten Verfahren zur Erkennung von Verschleiß und/oder einer Beschädigung einer Motor-Getriebe-Einheit mit einem Motor und einem abtriebsseitig mit demselben gekoppelten Getriebe, wird durch ein Detektionsmodul ein Ein- und/oder Ausgangsdrehmoment entweder direkt -beispielsweise mit einer Drehmomentmesswelle- oder indirekt -beispielsweise durch eine Messung des Motorstroms/der Motorströme- als eine mit dem Ein- und/oder Ausgangsdrehmoment eindeutig korrelierbare Messgröße bestimmt, wenn das Getriebe durch den Motor bewegt wird. Auf diese Weise wird für solche Bewegungen jeweils ein dem Drehmoment korrelierender Signalverlauf erzeugt, der das jeweils direkt oder indirekt bestimmte Ein- und/oder Ausgangsdrehmoment in Abhängigkeit von einer mit der Position des Getriebes korrelierten Größe wiedergibt.

Unter dem Begriff "Position des Getriebes" wird dabei die sich bei der Bewegung des Getriebes verändernde Orientierung und/oder Lage im Raum der Komponenten des Getriebes verstanden. Eine Position eines Getriebes kann also beispielsweise dadurch beschrieben werden, welche Zähne von den Getriebe bildenden Zahnrädern gerade miteinander im Eingriff stehen oder beispielsweise welchen Verdrehwinkel ein Zahnrad relativ zu einem Bezugspunkt aufweist.

Zur Vereinfachung wird nachfolgend der Begriff "Getriebeschaden" als Sammelbegriff für Verschleiß und Beschädigung von Zahnrädern bzw. Verzahnungsschäden sowie Lagerschäden verwendet.

Des Weiteren wird aus Gründen der Übersicht der zuvor beschriebene, mit dem Drehmoment korrelierende Signalverlauf, der das direkt oder indirekt bestimmte Ein- und/oder Ausgangsdrehmoment in Abhängigkeit von einer mit der Position des Getriebes korrelierten Größe wiedergibt, im Folgenden vereinfacht als "Signalverlauf" bzw. "Signalverläufe" bezeichnet.

Weiter werden nach dem erfindungsgemäßen Verfahren zumindest einige dieser Signalverläufe automatisiert analysiert. Bei dieser automatisierten Analyse wird jeweils ein Bereich der mit der Position des Getriebes korrelierten Größe identifiziert, in dem ein festgelegtes, für einen Getriebeschaden charakteristisches Merkmal auftritt.

Liegt ein Getriebeschaden vor, beeinflusst dieser regelmäßig das Drehmomentverhalten des Motors, der beispielsweise durch entsprechende Ansteuerung aufgrund einer temporär ineffizienten Momentenübertragung das Eingangsdrehmoment erhöht, um das erforderliche Ausgangsdrehmoment zu gewährleisten.

Im einfachsten Fall kann eine solche Analyse also einfach darin bestehen, einen Maximalwert in einem Signalverlauf zu bestimmen, eine Fläche unter einem Teilbereich eines Signalverlaufs zu bestimmen oder eine Stelle des Signalverlaufs zu bestimmen, in der dieser am ehesten eine vorgegebene Kurvenform aufweist. In komplexeren Fällen kann im Vorfeld der Anwendung des jeweiligen Kriteriums auch eine Vorauswahl oder Vorbehandlung von Signalverläufen erfolgen.

In jedem Signalverlauf, der analysiert wird, wird ein Bereich (der z. B. einer Winkelposition eines bestimmten Zahnrads des Getriebes entsprechen kann) identifiziert, der das für die Schadensdetektion verwendeten Kriterium (z. B. Maximum im Signalverlauf) erfüllt.

Dieser identifizierte Bereich wird automatisiert einer Klasse eines Histogramms zugeordnet (also, mit anderen Worten gesagt, in diese Klasse eingetragen, so dass sich die Zahl der dieser Klasse zugeordneten Ereignisse bzw. Bereiche erhöht, was insbesondere durch sofortiges Aufsummieren geschehen kann; aber beispielsweise auch durch Führen einer jeweiligen Liste der Signalverläufe, die einer Klasse zugeordnet werden), und es wird automatisiert überprüft, ob in dem Histogramm eine unerwartete Häufung von Einträgen in einer Klasse vorhanden ist (insbesondere durch Vergleich aufsummierter Ereigniszahlen oder Bestimmung und Vergleich von Listenlängen). Wenn dies der Fall ist, liegt tatsächlich ein Getriebeschaden vor. In diesem Fall, kann beispielsweise eine Warnmeldung erzeugt werden, sodass der Schaden behoben werden kann, ehe es zu einem Totalausfall der Motor-Getriebe-Einheit kommt.

Eine erste wesentliche Erkenntnis, die der Erfindung zu Grunde liegt, ist, dass die Anwendung eines Kriteriums für die Schadensdetektion auf Signalverläufe von Motor-Getriebe-Einheiten möglich ist, die keinen Getriebeschaden aufweisen, was dann im Regelfall zu im Wesentlichen zufallsverteilten Ergebnissen für die Position, an der dieses Kriterium den Getriebeschaden im jeweiligen Signalverlauf verortet, führt. Selbst wenn in einem Ausnahmefall bei einer speziellen Anwendung keine Zufallsverteilung dieser vermeintlichen Getriebeschäden auftritt, lässt sich die erwartete Ergebnisverteilung bei einem unbeschädigten Getriebe leicht ermitteln und der Schadensüberwachung zu Grunde legen, in dem beispielsweise eine gewichtete Hintergrundkorrektur erfolgt.

Wenn aber ein Getriebeschaden aufzutreten beginnt, wird die durch diesen verursachte und sich mit stärker werdendem Schaden verstärkende Änderung des Signalverlaufs in dem Bereich oder den Bereichen des Signalverlaufs, in denen beispielsweise ein beschädigter Zahn für die Drehmomentübertragung belastet wird, dazu führen, dass die erwartete Ergebnisverteilung sich signifikant verändert.

Eine zweite wesentliche Erkenntnis ist, dass es im Regelfall nicht notwendig ist, die exakte Position bzw. Art des Getriebeschadens zu bestimmen, sondern nur darauf ankommt zu erkennen, dass an irgendeiner Position ein Getriebeschaden vorhanden ist, da die daraus resultierende Notwendigkeit eines Getriebewechsels unabhängig davon ist, welche Komponente des Getriebes beschädigt ist.

Dies erlaubt einen Histogramm-basierten Ansatz, bei dem der bei der Aufnahme des Signalverlaufs durchfahrene Weg/Winkel in Bereiche aufgeteilt wird und für jeden dieser Bereiche gezählt wird, wie oft das Schadensdetektionskriterium in diesem Bereich erfüllt war. Dazu reicht ein Speicher mit einer Größe von wenigen Kilobyte aus, in dem nur sehr einfache Rechenoperationen ausgeführt werden müssen. Auch die Auswertung ob ein realer Getriebeschaden vorliegt, der sich durch das Abweichen der Verteilung in diesem Histogramm von einer erwarteten Verteilung, insbesondere einer Zufallsverteilung manifestiert, ist mathematisch auf einfache Vergleichsoperationen zurückführbar. Die benötigte Rechenleistung ist daher durch die Verwendung des erfindungsgemäßen Verfahrens ebenso gering wie der benötigte Speicherplatz.

In einer bevorzugten Ausführungsform des Verfahrens erfolgt eine automatisierte Vorauswahl der zu analysierenden Signalverläufe.

Insbesondere kann vorgesehen sein, dass bei der Vorauswahl nur Signalverläufe, die Drehmomentinformationen zu Getriebepositionen, die einen vorgegebenen Bereich komplett überdecken, beinhalten, zur weiteren Auswertung zugelassen werden.

Alternativ oder zusätzlich kann die Vorauswahl so ausgeführt werden, dass bei der Vorauswahl nur Signalverläufe, bei denen die Abweichung des absoluten Maximums und des absoluten Minimums vom Mittelwert des Signalverlaufs einen vorgegebenen Grenzwert nicht überschreiten, berücksichtigt werden. Der Sinn dieser Maßnahme erschließt sich bei der Betrachtung extremer Lastwechsel. Kurzzeitige Drehmomentspitzen vor allem an einer Drehrichtungs- und/oder Lastumkehr erschweren eine zuverlässige schadensanzeigende Merkmalsbestimmung.

In einer bevorzugten Variante des Verfahrens wird aus zu analysierenden Signalverläufen ein Gleichanteil bestimmt und entfernt, was die Analyse des Signalverlaufs ermöglicht. Diese Bestimmung kann beispielsweise erfolgen, indem ein gleitender Mittelwert des Signalverlaufs zur Glättung des Signalverlaufs gebildet wird; der Gleichanteil kann dann entfernt werden, indem dieser gleitende Mittelwert vom entsprechenden zugehörigen Messwert des Signalverlaufs subtrahiert wird.

Wenn zusätzlich eine Division durch den geglätteten Signalverlauf erfolgt, kann eine Korrektur drehmomentabhängiger periodisch auftretender Amplituden ermöglicht werden. Durch eine zusätzliche weitere Glättung und/oder Tiefpassfilterung können zudem eventuelle Störsignale aus dem Signalverlauf eliminiert werden.

Eine dazu alternative Vorgehensweise sieht vor, dass der Gleichanteil bestimmt und entfernt wird, indem ein Bandpassfilter auf den Signalverlauf angewendet wird. Ein Vorteil dieser Methode besteht darin, dass eine relativ geringe Rechenleistung zu ihrer Durchführung notwendig ist, was ihre Ausführung unter Standards im automobil Bereich erleichtert.

Vorzugsweise werden dabei die obere und untere Frequenzgrenze des Bandpassfilters als Funktion der Eingangsdrehzahl so gewählt, dass die Zahneingriffsfrequenz der zu überwachenden Komponenten des Getriebes den Hauptanteil der periodischen Schwankungen des Signals darstellen.

Eine Normierung des Signalverlaufs mit dem bestimmten Gleichanteil kann die Zuverlässigkeit der Analyse weiter verbessern.

Vorzugsweise wird das Histogramm in Form eines Zahlenarrays gespeichert, das für jeden Bereich der mit der Position des Getriebes korrelierten Größe die Anzahl $n_i$ der Signalverläufe, bei deren Analyse das für einen Getriebeschaden charakteristische Merkmal diesem Bereich zugeordnet wurde sowie die Anzahl der Überrollungen $r_i$ dieses Winkelbereichs speichert. Hierbei indiziert i den jeweiligen Winkelbereich. Dies stellt eine effiziente Speicherungsmethode dar, die einen geringen permanenten Speicherplatz benötigt.

Da mit steigender Messzyklusanzahl die Zahlen im Array sehr groß werden können und somit wiederum mehr Speicherplatz benötigen, sowie Winkelbereiche vorliegen die selten überrollt werden, erfolgt bevorzugt eine Korrektur bzw. eine Art Normierung der Schadensereignisse auf die Anzahl der Überrollungen. Zur Ermittlung der korrigierten Werte $n_{i-neu}$ und $r_{i-neu}$ innerhalb des Zahlenarrays wird die folgende Vorschrift verwendet:

$$1. \qquad n_{i-neu} = n_i - \bar{n} \cdot r_i / r_{sup}$$

$$2. \qquad r_{i-neu} = r_i - c$$

$$\text{Gleichung (1)}$$

Hierbei stellt $\bar{n}$ den Mittelwert aller Einträge $n_i$ dar. Die maximale Anzahl von Überrollungen im gesamten Array ist mit $r_{sup}$ bezeichnet. Eventuell entstehende negative $n_{i-neu}$ Werte werden auf einen konstanten, positiven Wert gesetzt. Des Weiteren werden mögliche Nachkommastellen entfernt. Zusätzlich wird zur Begrenzung der Dezimalstellen der $r_i$ nach der Zellenweisen Anwendung von Gleichung (1) 1. in Schritt 2. von Gleichung (1) ein konstanter Wert c (bspw. kleinstes $r_i$ im Zahlenarray) von den $r_i$ subtrahiert. Dieses Verfahren gewährleistet zum einen die Begrenzung der Dezimalstellen des gesamten Zahlenarrays sowie eine adäquate Korrelation der Anzahl der Überrollungen $r_i$ mit deren korrespondierenden Schadensereignissen $n_i$.

Um zu entscheiden, ob eine Getriebeschadenswarnung ausgegeben wird oder nicht, kann das Zahlenarray mittels eines Grenzwertvergleichs ausgewertet werden. Dabei hat sich ein Grenzwertvergleich gemäß der Formel

$$X = \frac{n_{max}}{\frac{1}{j-1}[\sum_i n_i - n_{max}]} \quad \rightarrow \quad \begin{cases} Getriebe \ iO, & wenn \ X < T_{rel} \\ Getriebe \ niO, & wenn \ X \geq T_{rel} \end{cases}$$

$$\text{Gleichung (2)}$$

bewährt. In dieser Formel stellt X die maximale Anzahl $n_{max}$ normiert auf den Mittelwert aller Einträge $n_i$ ohne $n_{max}$ und $T_{rel}$ den Schwellwert dar, ab dem eine Getriebeschadenswarnung ausgegeben wird. i stellt den Index des Winkelbereiches dar und ist die Laufvariable, über die summiert wird, j stellt die Anzahl der Klassen dar, in die der gesamte Winkelbereich eingeteilt ist.

In einer bevorzugten Ausführungsform der Erfindung ist vorgesehen, dass bei der automatisierten Überprüfung ob in dem Histogramm eine unerwartete Häufung von Einträgen in einer Klasse vorhanden ist, so dass Verschleiß und/oder ein Getriebeschaden vorliegt, ein nicht zufallsverteilter Hintergrund korrigiert wird. Auf diese Weise können systematische Effekte, die in Abhängigkeit vom konkreten Einsatz der Motor-Getriebe-Einheit auftauchen können, korrigiert werden.

Das vorgestellte Verfahren ermöglicht die Detektion von Getriebeschäden an unterschiedlichen Getriebetypen. Exemplarisch seien hier Stirn-, Schraubrad- und Schneckengetriebe genannt, die unter anderem auch für sicherheitsrelevante Anwendungen im Automobilbereich eingesetzt werden.

Je nach Anwendung kann es Situationen geben, in denen bestimmte Getriebeschäden sich nur in einer Laufrichtung der Motor-Getriebe-Anordnung bemerkbar machen. Wenn Signalverläufe nach Laufrichtung getrennt analysiert werden wird ein zuverlässiger Nachweis auch solcher Getriebeschäden möglich.

Die Erfindung wird nachfolgend anhand von Figuren näher erläutert. Es zeigt:

Fig. 1:  einen beispielhaften mechanischen Aufbau, der mittels des erfindungsgemäßen Verfahrens auf das Auftreten von Verzahnungsschäden überwacht werden kann,

Fig. 2:  einen Vergleich eines exemplarischen Signalverlaufs eines intakten Getriebes und eines beschädigten Getriebes,

Fig. 3:  eine Darstellung der Entwicklung des Maximums der gemessenen Signalverläufe eines Getriebes in Abhängigkeit vom Lastzyklus,

Fig. 4:  einen realen Signalverlauf eines beschädigten Getriebes einer Motor-Getriebe-Einheit,

Fig. 5:  ein Ablaufdiagramm einer möglichen Analyse von Signalverläufen,

Fig. 6:  das aus dem realen Signalverlauf aus Figur 4 nach der Ausführung des zweiten Schritts des Ablaufdiagramms aus Figur 5 erhaltene Zwischenergebnis,

Fig. 7:  das aus dem Zwischenergebnis aus Figur 6 nach der Ausführung des dritten Schritts des Ablaufdiagramms aus Figur 5 erhaltene Zwischenergebnis,

Fig. 8:  das nach dem Durchlaufen des Ablaufdiagramms aus Figur 5 erhaltene Histogramm für Signalverläufe die an zufällig verteilten Winkelpositionen das Schadenskriterium erfüllen (repräsentiert das Verhalten eines intakten Getriebes), und

Fig. 9:  das nach dem Durchlaufen des Ablaufdiagramms aus Figur 5 erhaltene Histogramm für ein beschädigtes Getriebe.

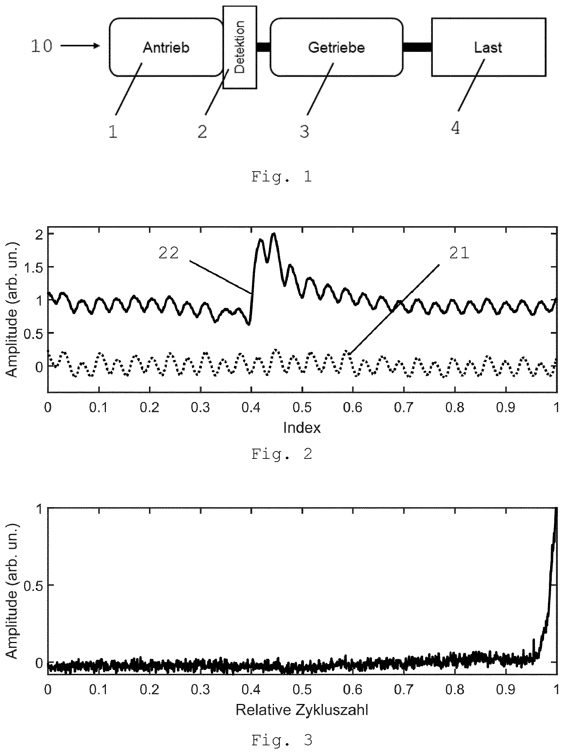

Figur 1 zeigt einen beispielhaften mechanischen Aufbau einer Motor-Getriebe-Einheit 10, der mittels des erfindungsgemäßen Verfahrens auf das Auftreten von Getriebeschäden überwacht werden kann. Die Motor-Getriebe-Einheit 10 weist zwingend einen Motor 1 auf, der insbesondere hier mittels eines Elektromotors realisiert ist. Dabei kommt es nicht wesentlich auf die konkrete Bauart des Elektromotors an; beispielsweise kann es sich um einen Servo-Motor, einen bürstenlosen Gleichstrommotor oder auch einen bürstenbehafteten Elektromotor handeln.

Essentiell ist, dass die Motor-Getriebe-Einheit 10 ein Detektionsmodul 2 aufweist, welches dazu ausgelegt und betreibbar ist, um die Aufzeichnung des Ein- und/oder Ausgangsdrehmoments entweder direkt oder indirekt als eine jeweils hiermit eindeutig korrelierbare, insbesondere dazu proportionale Messgröße, wie beispielsweise den -zeitaufgelösten- Motorstrom, zu ermöglichen. Diese Messgröße wird während des Betriebs der Motor-Getriebe-Einheit 10 also wiederholt gemessen, während das Getriebe bzw. die Bauteile, die es bilden, in unterschiedlichen Positionen, insbesondere Eingriffspositionen stehen, so dass während einer Bewegung der Motor-Getriebe-Einheit 10 jeweils ein Signalverlauf erzeugt wird, der das jeweils direkt oder indirekt bestimmte Ein- und/oder Ausgangsdrehmoment in Abhängigkeit von einer mit der Position des Getriebes korrelierten Größe wiedergibt.

Mit dem Antrieb 1 wird das zu überwachende Getriebe 3, das hier exemplarisch ein Schraubrad-/Schneckengetriebe ist, angetrieben, so dass unter dem Einfluss einer Last 4, deren Größe wechseln kann, eine Bewegung durch den Antrieb hervorgerufen wird, also beispielsweise ein Stößel verfahren wird.

Als Kenngröße für das Auftreten von Verzahnungsschäden dienen erfindungsgemäß die durch dieses Detektionsmodul 2 aufgenommenen Signalverläufe, die die direkte oder indirekte Erfassung des Drehmomentverlaufs eines unter Last stehenden Getriebes ermöglichen und die Identifikation von Unregelmäßigkeiten im Signalverlauf ermöglichen, die eine frühzeitige Schadensdetektion erlauben.

Figur 2 veranschaulicht die Verwendbarkeit von mit einem solchen Detektionsmodul 2 aufgenommenen Signalverläufen für die Identifikation eines Getriebeschadens. Dargestellt sind ein Drehmomentverlauf 21 eines intakten Getriebes 3 als Strichlinie und der Drehmomentverlauf 22 eines beschädigten Getriebes 3, bei dem ein Zahnfuß einen Riss aufweist, als durchgezogene Linie.

Die dargestellten Daten repräsentieren in diesem Beispiel mittels einer Drehmomentmesswelle erfasste Eingangsdrehmomente als Funktion einer zur Drehwinkel korrelierten Größe, während das jeweilige Getriebe 3 mit definierter Geschwindigkeit aus einer definierten Startposition in eine definierte Endposition gefahren wird. Die jeweiligen Messwerte sind in diesem Beispiel gegen einen relativen Abtastindex, der damit eine zur Messzeit proportionale Größe ist und somit reproduzierbar einer gegebenen Getriebeposition zugeordnet werden kann, aufgetragen, um den jeweiligen Signalverlauf zu erzeugen.

Die Getriebeposition kann allgemein durch eine Vielzahl von mit dieser korrelierten Größen ermittelt werden, beispielsweise in Abhängigkeit von einer Laufzeit des Motors, durch eine Positionsüberwachung des Rotors des Motors, durch eine Überwachung der Position eines durch die Motor-Getriebe-Einheit 10 bewegten Stößels oder ähnliche Maßnahmen.

Der Signalverlauf 22 des beschädigten Getriebes 3 unterscheiden sich durch auftretende Maxima von dem Signalverlauf 21 des intakten Getriebes 3. Diese signifikant ausgeprägten Modulationen im Signalverlauf 22 werden durch den Eingriff eines beschädigten Zahnes hervorgerufen, die dazu führen, dass der Antriebsmotor aufgrund der ineffizienten Momentenübertragung das Eingangsdrehmoment erhöht, um das erforderliche Ausgangsdrehmoment zu gewährleisten.

Solche Anomalien können verwendet werden, um Kriterien für die Detektion von Beschädigungen zu definieren. Beispiele für solche Kriterien sind Extremwerte der Daten (Maxima, Minima etc.), die Fläche (Summe, Integral) unter den Maxima/Minima eines bestimmten mit dem Drehwinkel korrelierenden Bereiches oder ähnliche Kenngrößen. Tritt eine Beschädigung auf, so steigen ein oder mehrere dieser Merkmale signifikant an und markieren den Beginn einer auftretenden Beschädigung.

Zur Veranschaulichung dieser Tatsache zeigt Figur 3 eine Darstellung eines exemplarischen, aus dem Vergleich gemäß Figur 2 ableitbaren Merkmals, konkret in Form des Maximums der einzelnen Signalverläufe, in Abhängigkeit vom jeweiligen Lastzyklus. Ein Lastzyklus ist dabei jeweils das Verfahren des Getriebes 3 aus der definierten Startposition in die definierte Endposition. Für jeden dieser Lastzyklen ist durch das Detektionsmodul 2 ein Drehmomentverlauf gemessen worden. Jeder der in Figur 3 eingetragenen Datenpunkte entspricht der maximalen Amplitude des Drehmomentverlaufs des zugehörigen Lastzykluses.

Man erkennt in Figur 3, dass etwa nach 95 Prozent der maximal durchlaufenen Lastzyklusanzahl der Wert dieses Merkmals, also der maximalen Amplitude im jeweiligen mit dem Drehmoment korrelierten Signalverlauf, anzusteigen beginnt, was in diesem Beispiel ein Indikator für den Beginn eines eintretenden Zahnbruchs ist.

Unter idealen Bedingungen, wie sie beispielsweise bei Dauerlaufversuchen mit Motor-Getriebe-Einheiten 10 im Labor realisierbar sind, lassen sich also Getriebeschäden aus direkt oder indirekt gewonnenen Drehmomentmessdaten sicher ermitteln. Dabei sind diese Bedingungen in zweierlei Hinsicht ideal:
Erstens sind die Umgebungsbedingungen kontrollierbar und folglich annähernd konstant, was die präzise Identifikation der Merkmale erleichtert. Bei einer in situ erfolgenden Messung eines Betriebs einer Motor-Getriebe-Einheit 10 in einer realen Anwendung stellt sich die Lage deutlich komplexer dar. Die Signalverläufe zweier aufeinander folgender Verfahrzyklen können hierbei beispielsweise in Drehzahl und zeitlichem Verlauf der Abtriebslast drastisch voneinander abweichen.

Zweitens stehen für die automatisierte Datenauswertung unter Laborbedingungen regelmäßig Rechenleistung und Speicherplatz in großem Umfang zur Verfügung, während diese Ressourcen bei einem Betrieb unter Realbedingungen (z. B. in einem Fahrzeug) in geringerem Maße vorliegen.

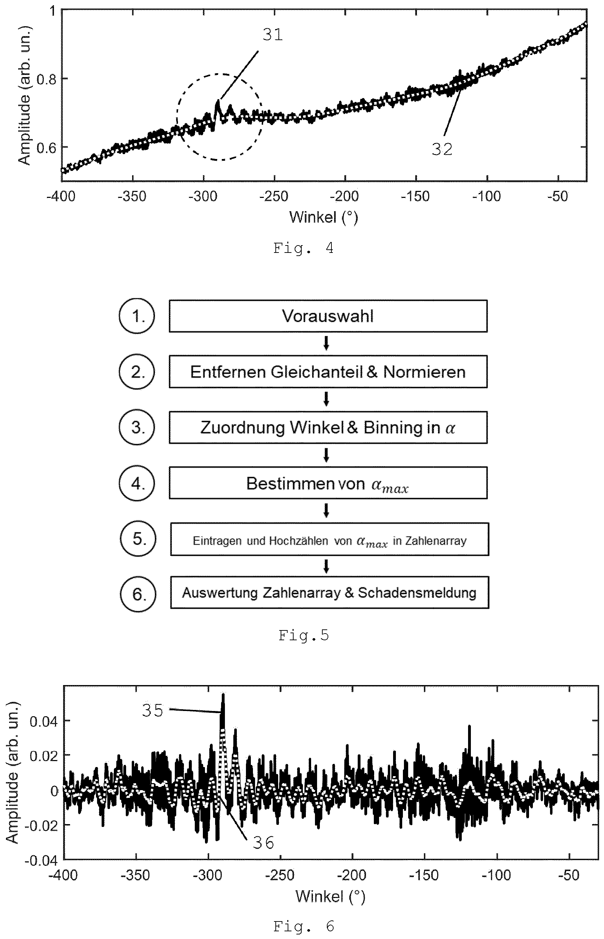

Um diesen Sachverhalt zu verdeutlichen, zeigt Figur 4 ein Beispiel eines mit einer Drehmomentmesswelle ermittelten Drehmomentverlaufs 31 einer Motor-Getriebeeinheit 10, mit einem beschädigten Getriebe 3, die im Betrieb wechselnder Last ausgesetzt ist, als Volllinie. Dabei ist hier das Drehmoment gegen eine Winkelposition am Ausgang der Motor-Getriebe-Einheit aufgetragen, die beispielsweise direkt mit einem Drehgeber oder indirekt aus dem zeitlichen Signalverlauf ermittelt werden kann. Der Bereich, in dem die Auswirkungen des beschädigten Zahns zu erkennen sind, ist dabei mit einem Kreis hervorgehoben; ein gleitender Mittelwert 32 des Messsignals ist als Strichlinie dargestellt. An diesem Beispiel wird unmittelbar klar, wie komplex die Aufgabe, einen solchen Schaden in einem Signalverlauf zu erkennen und zuverlässig einer Winkelposition zuzuordnen selbst dann ist, wenn sicher ist, dass ein Schaden vorliegt.

Die Herausforderung besteht hier darin, dass mit möglichst geringem Rechenaufwand eine Vergleichbarkeit zwischen Messsignalen, aufgezeichnet unter verschiedenen Messbedingungen, erzielt werden muss.

Wendet man die Schritte der in Figur 5 dargestellten Analyseprozedur an, wird selbst in diesem Fall aber eine zuverlässige Überwachung auf Getriebeschäden unter Einsatz überschaubarer Hardware-Ressourcen möglich.

Zunächst wird dabei eine Vorauswahl der zu verwendenden Messzyklen getroffen (Punkt (1.) in Figur 5). Hierbei werden nur Zyklen mit definierten Winkelbereichen für die Auswertung zugelassen. Des Weiteren soll die Abweichung des absoluten Maximums und Minimums vom Mittelwert des Signalverlaufs einen Grenzwert nicht überschreiten. Die erste Maßnahme gewährleistet, dass alle gewünschten Winkelbereiche im Signalverlauf enthalten sind und gegebenenfalls unerwünschte Bereiche des Signalverlaufs vernachlässigt werden; die zweite, dass die durch das Abtriebsmoment verursachten Schwankungen nicht unkorrigierbar groß werden.

In Punkt (2.) in Figur 5 wird der Gleichanteil entfernt. Dies kann insbesondere über zwei Ansätze geschehen:

I) Es wird die Differenz des stark geglätteten Signalverlaufs (Strichlinie in Figur 4) und des ursprünglichen Signalverlaufs gebildet (Volllinie in Figur 4). Des Weiteren kann optional eine Division durch den stark geglätteten Signalverlauf erfolgen um eine Korrektur drehmomentabhängiger periodisch auftretender Amplituden vorzunehmen und/oder optional eine weitere Glättung und/oder Tiefpassfilterung durchgeführt werden, um eventuelle Störsignale aus dem Signalverlauf zu eliminieren.

II) Es wird ein Bandpassfilter auf das Signal angewendet. Die obere und untere Frequenzgrenze können dabei als Funktion der Eingangsdrehzahl so gewählt werden, dass die Zahneingriffsfrequenz der zu betrachtenden Getriebekomponente den Hauptanteil der periodischen Schwankungen des Signalverlaufs darstellen. Ein Vorteil dieser Methode liegt in der einfacheren Umsetzung in gängigen Programmiersprachen.

Für beide Ansätze gilt, dass sie mit geringem Rechenaufwand und einfachen mathematischen Operationen durchgeführt werden können.

Figur 6 zeigt als Volllinie das korrigierte Signal 35, das man nach Anwendung der Methode I) erhält und zur besseren Veranschaulichung den gleitenden Mittelwert 36 über dieses korrigierte Signal als Strichlinie. Insbesondere nach der Mittelwertbildung kann das geschulte Auge nun oberhalb von etwa - 300° Maxima im korrigierten Signalverlauf feststellen, die auf einen Getriebeschaden hindeuten.

In den nächsten beiden Schritten, (3.) und (4.) in Figur 5, wird nun der Bereich der mit der Position des Getriebes korrelierten Größe identifiziert, dem ein festgelegtes, für einen Getriebeschaden charakteristisches Merkmal für den jeweiligen Signalverlauf zugeordnet werden kann. In diesem Beispiel stellt das Auftreten des Maximums im Signalverlauf das für einen Getriebeschaden charakteristische Merkmal dar. In Schritt (4.) in Figur 5 wird die Position $\alpha_{max}$ bei der das charakteristische Getriebeschadenmerkmal auftritt, bestimmt.

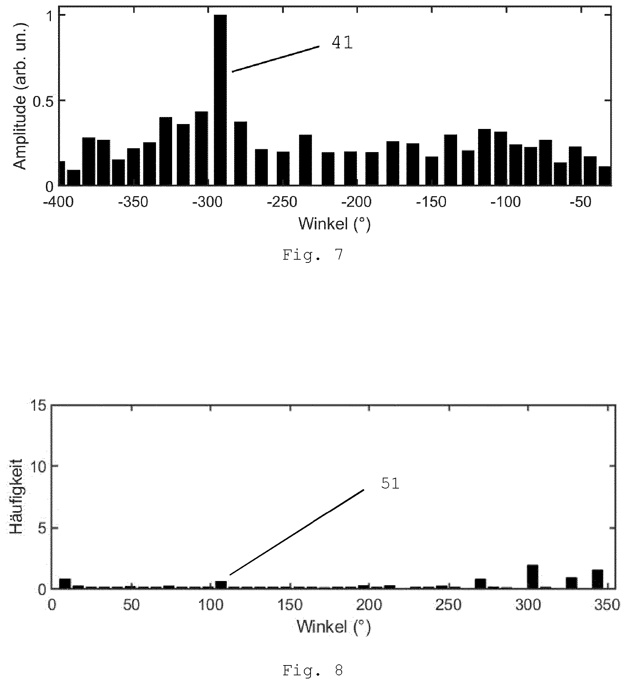

Dazu wird in diesem Fall die Winkelskala der Figur 6 in eine Winkelskala überführt, die die korrespondierende Position der überwachten Getriebekomponente (die immer zwischen 0° und 360° liegt) angibt. Des Weiteren erfährt der korrigierte Signalverlauf eine Klasseneinteilung, wobei jede Klasse einen festen Winkelbereich umfasst, in diesem Beispiel jeweils 10° der Winkelskala. Alle Werte des korrigierten Signalverlaufs innerhalb einer Klasse werden aufsummiert. Das daraus resultierende Signal 41 ist schematisch in Form eines Balkendiagramms in Figur 7 dargestellt. Der Winkel $\alpha_{max}$ an der Position des Balkens mit dem höchsten Wert im Balkendiagramm (41) wird identifiziert; er entspricht dem jeweiligen Bereich, der mit der Position des Getriebes korrelierten Größe identifiziert wird, in dem das festgelegte, für einen Getriebeschaden charakteristische Merkmal für den jeweiligen Signalverlauf zu finden ist. Dies führt zu einer erheblichen Reduktion der weiterzuverarbeitenden Datenmenge, da der hochaufgelöste korrigierte Signalverlauf in eine Struktur mit wenigen relevanten Datenpunkten, den jeweiligen Bins mit der jeweils zugehörigen Summe, überführt wird.

Liegt aufgrund des Detektionsmoduls 2 der detektierte Signalverlauf als Funktion der Winkelskala, die die korrespondierende Position der überwachten Getriebekomponente angibt, vor, kann der nach den Schritten (1.) und (2.) in Figur 5 erzeugte korrigierte Signalverlauf direkt einer Klasseneinteilung und der Aufsummierung innerhalb einer Klasse unterzogen werden.

Für jeden die Vorauswahl (Schritt (1.) in Figur 5) passierenden einzelnen Signalverlauf wird ein $\alpha_{max}$ bestimmt. Dieser Wert wird in ein Histogramm (51,52), in dem die Häufigkeit, mit der $\alpha_{max}$ auftritt, abgebildet ist, eingetragen (Punkt (5.) in Figur 5).

In Figur 8 ist ein Histogramm (51) dargestellt, das auf zufällig erzeugten Signalverläufen basiert die ein intaktes Getriebe repräsentieren sollen. Diese Signalverläufe wurden mit dem zuvor beschriebenen Algorithmus gemäß Figur 5 ausgewertet. Erwartungsgemäß ist zu erkennen, dass die extrahierten $\alpha_{max}$ annähernd zufällig verteilt sind, so dass das Histogramm (51) einen gleichverteilten Grundpegel ausbildet. Es kann bei manchen Anwendungen auch vorkommen, dass dieser gleichverteilte Grundpegel sich erst ergibt, wenn man einen systematischen Effekt, der diese Verteilung überlagert, korrigiert.

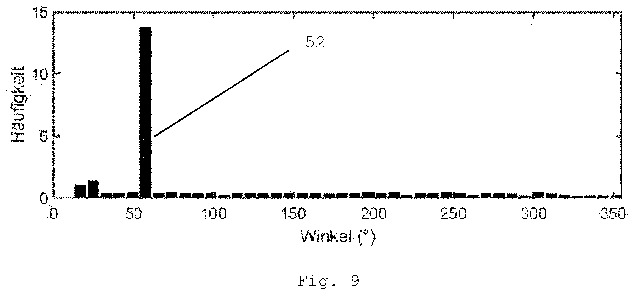

Werden den etwa dreißig ausgewerteten Datensätzen weitere dreißig Signalverläufe hinzugefügt, bei denen, in diesem Beispiel, ein beschädigtes Schneckenrad vorliegt, ergibt sich das in Figur 9 dargestellte Histogramm 52, das nun ein markantes Maximum an der Stelle, an der der beschädigte Zahn belastet wird, hier bei etwa 70°, aufweist.

Um den Anforderungen eines geringen verfügbaren permanenten Speicherplatzes zu genügen, benötigt das erfindungsgemäße Verfahren lediglich ein Zahlenarray mit einer Größe weniger Kilobyte, welches permanent hinterlegt werden muss. Tabelle 1 zeigt schematisch wie bei einer Klassengröße von 10° und dem Klassenindex i, ein solches Array aufgebaut ist und auf welche Weise die einzelnen Zellen "befüllt" werden können.

Tabelle 1

| Winkel $\alpha$ (°) | 0 | 10 | 20 | 30 | 40 | ... | 360 |
|---|---|---|---|---|---|---|---|
| Anzahl $n_i$ | 2 | 4 | 9 | 3 | 25 | ... | 0 |
| Überrollungen $r_i$ | 30 | 28 | 25 | 25 | 5 | ... | 2 |

Hierbei werden lediglich die Anzahl $n_i$ der einzelnen Ereignisse an bestimmten Winkelpositionen sowie die Anzahl der Überrollungen $r_i$ dieses Winkelbereichs hochgezählt und gespeichert.

Beispielsweise kann eine einfache Abfrage der Winkelposition des Maximums im Zahlenarray, kombiniert mit einem Grenzwertvergleich, eine Beurteilung über den Zustand des Getriebes erlauben. Da mit steigender Messzyklusanzahl die Zahlen im Array sehr groß werden können und somit wiederum mehr Speicherplatz benötigen, sowie Winkelbereiche vorliegen die selten überrollt werden, muss eine Korrektur bzw. eine Art Normierung der Schadensereignisse auf die Anzahl der Überrollungen erfolgen. Zur Ermittlung der korrigierten Werte $n_{i\text{-neu}}$ und $r_{i\text{-neu}}$ innerhalb des Zahlenarrays wird die folgende Vorschrift verwendet:

$$1. \qquad n_{i-neu} = n_i - \bar{n} \cdot r_i / r_{sup}$$

$$2. \qquad r_{i-neu} = r_i - c$$

Gleichung (1)

Hierbei stellt $\bar{n}$ den Mittelwert aller Einträge $n_i$ dar. Die maximale Anzahl von Überrollungen im gesamten Array ist mit $r_{sup}$ bezeichnet. Eventuell entstehende negative $n_{i\text{-neu}}$ Werte werden auf einen konstanten, positiven Wert gesetzt. Des Weiteren werden mögliche Nachkommastellen entfernt. Zusätzlich wird zur Begrenzung der Dezimalstellen der $r_i$ nach der Zellenweisen Anwendung von Gleichung (1) 1. in Schritt 2. von Gleichung (1) ein konstanter Wert c (bspw. kleinstes $r_i$ im Zahlenarray) von den $r_i$ subtrahiert. Dieses Verfahren gewährleistet zum einen die Begrenzung der Dezimalstellen des gesamten Zahlenarrays sowie eine adäquate Korrelation der Anzahl der Überrollungen $r_i$ mit deren korrespondierenden Schadensereignissen $n_i$.

Nach jeder Anwendung der Vorschrift aus Gleichung (1) auf alle Zellen erlaubt ein Grenzwertvergleich, eine Beurteilung über den Zustand des Getriebes. Gleichung (2) stellt den Grenzwertvergleich symbolisch dar:

$$X = \frac{n_{max}}{\frac{1}{j-1}\left[\sum_i n_i - n_{max}\right]} \quad \rightarrow \quad \begin{cases} Getriebe\ iO, & wenn\ X < T_{rel} \\ Getriebe\ niO, & wenn\ X \geq T_{rel} \end{cases}$$

Gleichung (2)

Hierbei ist X die maximale Anzahl $n_{max}$ dividiert durch den Mittelwert der einzelnen Einträge $n_i$ ohne $n_{max}$. Hierbei stellt j die Anzahl der Array-Klassen dar. Überschreitet X einen zuvor festgelegten relativen Grenzwert $T_{rel}$ wird das Getriebe als "nicht in Ordnung" deklariert. Folglich kann eine Wartungsempfehlung ausgegeben werden (Figur 4, Schritt (6.)).

Die aufgeführte Logik stellt eine rechenressourcenschonende Möglichkeit für eine Zustandsüberwachung einer Motor-Getriebe-Einheit 10 dar, bei der ohne zusätzliche Hardware eine Systemüberwachung mit möglichst geringen Mehrkosten realisiert werden kann.

Bezugszeichenliste

1 Motor
2 Detektionsmodul
3 Getriebe
4 Last
10 Motor-Getriebe-Einheit
21 Signalverlauf

22      Signalverlauf
31      Signalverlauf
32      gleitender Mittelwert
35      korrigierter Signalverlauf
36      gleitender Mittelwert
41      Histogramm
51      Histogramm
52      Histogramm

**Patentansprüche**

1.  Verfahren zur Erkennung von Verschleiß, Verzahnungsschäden und /oder Lagerschäden einer Motor-Getriebe-Einheit (10) mit einem Motor (1) und einem abtriebsseitig mit demselben gekoppelten Getriebe (3), bei dem

    - durch ein Detektionsmodul (2) ein Ein- und/oder Ausgangsdrehmoment entweder direkt oder indirekt als eine mit dem Ein- und/oder Ausgangsdrehmoment eindeutig korrelierbare Messgröße bestimmt wird, wenn das Getriebe (3) durch den Motor (1) bewegt wird, so dass für solche Bewegungen jeweils ein Signalverlauf (21,22,31) erzeugt wird, der das jeweils direkt oder indirekt bestimmte Ein- und/oder Ausgangsdrehmoment in Abhängigkeit von einer mit der Position des Getriebes (3) korrelierten Größe wiedergibt,
    - zumindest einige dieser Signalverläufe (21,22,31) automatisiert analysiert werden, wobei ein Bereich der mit der Position des Getriebes (3) korrelierten Größe identifiziert wird, dem ein festgelegtes, für einen Getriebeschaden charakteristisches Merkmal für den jeweiligen Signalverlauf (21,22,31) zugeordnet werden kann, **gekennzeichnet dadurch, dass**
    - der identifizierte Bereich automatisiert einer Klasse eines Histogramms (51,52) zugeordnet wird, und
    - automatisiert überprüft wird, ob in dem Histogramm (51,52) eine unerwartete Häufung von Einträgen in einer Klasse vorhanden ist, so dass Verschleiß und/oder ein Getriebeschaden vorliegt.

2.  Verfahren nach Anspruch 1,
    **dadurch gekennzeichnet, dass** eine automatisierte Vorauswahl der zu analysierenden Signalverläufe (21,22,31) erfolgt.

3.  Verfahren nach Anspruch 2,
    **dadurch gekennzeichnet, dass** bei der Vorauswahl nur Signalverläufe (21,22,31), die Drehmomentinformationen zu Getriebepositionen, die vorgegebene Bereiche überstreichen beinhalten, zur weiteren Auswertung zugelassen werden.

4.  Verfahren nach Anspruch 2 oder 3,
    **dadurch gekennzeichnet, dass** bei der Vorauswahl nur Signalverläufe (21,22,31), bei denen die Abweichung des globalen Maximums und des globalen Minimums vom Mittelwert des Signalverlaufs einen vorgegebenen Grenzwert nicht überschreiten, zur weiteren Auswertung zugelassen werden.

5.  Verfahren nach einem der Ansprüche 1 bis 4,
    **dadurch gekennzeichnet, dass** aus zu analysierenden Signalverläufen (21,22,31) ein Gleichanteil bestimmt und entfernt wird.

6.  Verfahren nach Anspruch 5,
    **dadurch gekennzeichnet, dass** der Gleichanteil bestimmt wird, indem ein gleitender Mittelwert (32) des Signalverlaufs (21,22) zur Glättung des Signalverlaufs gebildet wird und dass der Gleichanteil entfernt wird, indem dieser gleitende Mittelwert (32) vom entsprechenden zugehörigen Messwert des ungeglätteten Signalverlaufs (21,22,31) subtrahiert wird.

7.  Verfahren nach Anspruch 6,
    **dadurch gekennzeichnet, dass** ferner eine Division durch den geglätteten Signalverlauf erfolgt, um eine Korrektur drehmomentabhängiger periodisch auftretender Amplituden vorzunehmen und/oder optional eine weitere Glättung und/oder Tiefpassfilterung durchgeführt werden, um eventuelle Störsignale aus dem Signalverlauf zu eliminieren.

8.  Verfahren nach Anspruch 6,
    **dadurch gekennzeichnet, dass** der Gleichanteil bestimmt und entfernt wird, indem ein Bandpassfilter auf den Signalverlauf (21,22,31) angewendet wird.

9. Verfahren nach Anspruch 8,
**dadurch gekennzeichnet, dass** die obere und untere Frequenzgrenze des Bandpassfilters als Funktion der Eingangsdrehzahl so gewählt werden, dass die Zahneingriffsfrequenz der zu überwachenden Komponente des Getriebes (3) den Hauptanteil der periodischen Schwankungen des Signals darstellen.

10. Verfahren nach einem der Ansprüche 5 bis 9,
**dadurch gekennzeichnet, dass** eine Normierung des Signalverlaufs (21,22,31) mit dem bestimmten Gleichanteil erfolgt.

11. Verfahren nach einem der Ansprüche 1 bis 10,
**dadurch gekennzeichnet, dass** das Histogramm (50,51) als ein Zahlenarray gespeichert wird, das für jeden Bereich der mit der Position des Getriebes (3) korrelierten Größe die Anzahl $n_i$ der Signalverläufe (21,22,31), bei deren Analyse das für einen Getriebeschaden charakteristische Merkmal diesem Bereich zugeordnet wurde sowie die Anzahl der Überrollungen $r_i$ dieses Winkelbereichs speichert.

12. Verfahren nach Anspruch 11,

   **dadurch gekennzeichnet, dass** das Zahlenarray mindestens einmal mit korrigierten Werte $n_{i-neu}$ und $r_{i-neu}$ aktualisiert wird, die gemäß der Vorschrift

   1.

$$n_{i-neu} = n_i - \bar{n} \cdot r_i/r_{sup}$$

   2.

$$r_{i-neu} = r_i - c$$

   bestimmt werden, wobei
   $\bar{n}$ den Mittelwert aller Einträge $n_i$ darstellt,
   $r_{sup}$ die maximale Anzahl von Überrollungen im gesamten Array bezeichnet,
   eventuell entstehende negative $n_{i-neu}$ Werte auf einen konstanten, positiven Wert gesetzt werden,
   mögliche Nachkommastellen entfernt werden,
   und c ein konstanter Wert, insbesondere das kleinste $r_i$ im Zahlenarray vor der Aktualisierung, ist.

13. Verfahren nach Anspruch 11 oder 12,
**dadurch gekennzeichnet, dass** das Zahlenarray mittels eines Grenzwertvergleichs ausgewertet wird.

14. Verfahren nach Anspruch 13,

   **dadurch gekennzeichnet, dass** der Grenzwertvergleich gemäß der Formel

$$X = \frac{n_{max}}{\frac{1}{j-1}\left[\sum_i n_i - n_{max}\right]} \quad \rightarrow \quad \begin{cases} Getriebe\ iO, & wenn\ X < T_{rel} \\ Getriebe\ niO, & wenn\ X \geq T_{rel} \end{cases}$$

   ausgeführt wird, wobei
   X der berechnete vorliegende Wert ist,
   $T_{rel}$ den Schwellwert darstellt, ab dem eine Getriebeschadenswarnung ausgegeben wird,
   $n_{max}$ die maximale Anzahl der Schadensereignisse im Zahlenarray, beschreibt,
   $r_{max}$ die dazugehörige Anzahl der Überrollungen angibt,
   $n_i$ den i-ten Eintrag der Schadensereignisse im Zahlenarray darstellt,
   $r_i$ die jeweils entsprechende Anzahl der Überrollungen und j die Gesamtanzahl der Winkelbereiche ist.

**15.** Verfahren nach einem der Ansprüche 1 bis 14,
**dadurch gekennzeichnet, dass** bei der automatisierten Überprüfung ob in dem Histogramm (51,52) eine unerwartete Häufung von Einträgen in einer Klasse vorhanden ist, so dass Verschleiß und/oder ein Getriebeschaden vorliegt, ein nicht zufallsverteilter Hintergrund korrigiert wird.

**16.** Verfahren nach einem der Ansprüche 1 bis 15,
**dadurch gekennzeichnet, dass** Signalverläufe (21,22,31) nach Laufrichtung getrennt analysiert werden.

**Claims**

**1.** Method for detecting wear, damage to the gearing and/or damage to the bearings, in an engine transmission unit (10), having an engine (1) and a transmission (3) which is coupled to the engine on its output side, in which

- when the transmission (3) is put into motion by the engine (1), an input and/or output torque is either directly determined, or indirectly as a measurement variable which can be unambiguously correlated with the input and/or output torque, by means of a detection module (2), in order to generate a signal curve (21, 22, 31) for such motion which describes each directly or indirectly determined input and/or output torque in dependency on a variable which correlates with the position of the transmission (3),
- at least some of these signal curves (21, 22, 31) are automatically evaluated, wherein a range of the variable which correlates with the position of the transmission (3) is identified, to which a value which is typical for a transmission defect can be assigned for the respective signal curve (21, 22, 23),
**characterized in that**
- the identified range is automatically assigned to a class of a histogram (51, 52) and
- it is automatically verified whether there is an unexpected proliferation of entries in any class in the histogram (51, 52), indicating the presence of wear and/or damage to the transmission.

**2.** Method in accordance with claim 1,
**characterized in that** an automatic preliminary selection of the signal curves (21, 22, 31) intended for evaluation is carried out.

**3.** Method in accordance with claim 2,
**characterized in that**, during the automatic preliminary selection, only signal curves (21, 22, 31) which contain torque data relating to positions of the transmission which cover the specified ranges is accepted for further evaluation.

**4.** Method in accordance with claim 2 or 3,
**characterized in that**, during the preliminary selection, only those signal curves (21, 22, 31) in which the deviation of the global maximum and of the global minimum from the average value of the signal curve do not exceed a specified threshold value are accepted for further evaluation.

**5.** Method in accordance with any of claims 1 to 4,
**characterized in that** a direct component is determined from the analyzed signal curves (21, 22, 31) and is removed.

**6.** Method in accordance with claim 5,
**characterized in that** the direct component is determined by forming a moving average (32) of the signal curve (21, 22) for the smoothing of the signal curve and **in that** the direct component is removed by subtracting this moving average (32) from the corresponding related measured value of the unsmoothed signal curve (21, 22, 31).

**7.** Method in accordance with claim 6,
**characterized in that**, in addition, a division by the smoothed signal curves is performed in order to carry out a correction of periodically occurring torque-dependent amplitudes and/or, optionally, a further smoothing and/or a low pass filtering is carried out in order to eliminate any possible interference signals from the signal curve.

**8.** Method in accordance with claim 6,
**characterized in that** the direct component is determined and removed by applying a band pass filter to the signal curve (21, 22, 31).

**9.** Method in accordance with claim 8,

EP 4 357 749 B1

**characterized in that** the upper and the lower frequency limits of the band pass filter are selected as a function of the input rotational speed so that the gear mesh frequencies of the monitored components of the transmission (3) represent the major portion of the periodic fluctuations of the signal.

10. Method in accordance with any of claims 5 to 9,
**characterized in that** a normalization of the signal curve (21, 22, 31) is carried out with the determined direct component.

11. Method in accordance with any of claims 1 to 10,
**characterized in that** the histogram (50, 51) is saved as an array of numbers which, for each range of the value correlating with the position of the transmission (3), the number $n_i$ of the signal curves (21, 22, 31), during the evaluation of which the value characteristic for a transmission defect is assigned to this range, as well as the number $r_i$ of overrollings of this angular range. are saved.

12. Method in accordance with claim 11,

**characterized in that** the array of numbers is updated at least once with corrected values $n_{i\text{-new}}$ and $r_{i\text{-new}}$, which are determined in accordance with the specification

1.

$$n_{i-neu} = n_i - \bar{n} \cdot r_i / r_{sup}$$

2.

$$r_{i-neu} = r_i - c$$

wherein $n$ represents the average value of all assignments $n_i$,
$r_{sup}$ designates the maximum number of overrollings in the entire array,
any possibly occurring negative $n_{i\text{-new}}$ values are set to a constant positive value, any existing digits following the decimal point are removed,
and c is a constant value, in particular, is the smallest $r_i$ in the array of numbers before the update.

13. Method in accordance with claim 11 or 12,
**characterized in that** the array of numbers is evaluated by means of a threshold value comparison.

14. Method in accordance with claim 13,

**characterized in that** the threshold value comparison is carried out in accordance with the equation

$$X = \frac{n_{max}}{\frac{1}{j-1}\left[\sum_i n_i - n_{max}\right]} \quad \rightarrow \quad \begin{cases} Getriebe\ iO, & wenn\ X < T_{rel} \\ Getriebe\ niO, & wenn\ X \geq T_{rel} \end{cases}$$

wherein

X is the present calculated value,
$T_{rel}$ represents the threshold value at which a warning of a transmission defect is issued,
$n_{max}$ describes the maximum number of damage occurrences in the array of numbers, $r_{max}$ indicates the matching number of overrollings,
$n_i$ represents the i - th entry of the damage occurrences in the array of numbers, $r_i$ is the corresponding number of overrollings and j is the total number of angular ranges.

15. Method in accordance with any of claims 1 to 14,
**characterized in that**, during the automatic verification of whether an unexpected proliferation of entries in any class is present in the histogram (51, 52), indicating the presence of wear and/or a transmission defect, a non-randomly arranged background is corrected.

**16.** Method in accordance with any of claims 1 to 15,
**characterized in that** the signal curves (21, 22, 31) are analyzed separately according to their running direction.

**Revendications**

**1.** Procédé d'identification d'usure, de dommages de dentures et/ou de dommages de paliers d'un ensemble moteur-transmission (10) comprenant un moteur (1) et une transmission (3) couplée à celui-ci, côté sortie, selon lequel :

- on détermine avec un module de détection (2) une grandeur de mesure en corrélation univoque avec un couple d'entrée et/ou de sortie, directement ou indirectement comme couple d'entrée et/ou de sortie lorsque la transmission (3) est entraînée par le moteur (1) de sorte que pour de tels mouvements, on génère une courbe de signal (21, 22, 31) respective, qui reproduit le couple d'entrée et/ou de sortie, déterminé respectivement, de manière directe ou indirecte, en fonction d'une grandeur en corrélation avec la position de la transmission (3),
- on analyse, de manière automatique au moins quelques unes de ces courbes de signal (21, 22, 31), selon lequel
- on identifie une zone de la grandeur corrélée avec la position de la transmission (3), à laquelle on peut associer un élément caractéristique d'un dommage de transmission pour la courbe de signal respective (21, 22, 31), procédé **caractérisé en ce que**
- on associe la zone identifiée de manière automatique à une classe d'un histogramme (51, 52), et
- on vérifie, de manière automatique, si dans l'histogramme (51, 52) il y a une accumulation inattendue d'enregistrements dans une classe, pour de l'usure et/ou un dommage de transmission.

**2.** Procédé selon la revendication 1,
**caractérisé par**
une présélection automatique des courbes de signal à analyser (21, 22, 31).

**3.** Procédé selon la revendication 2,
**caractérisé en ce que**
pour la présélection, on ne conserve que les courbes de signal (21, 22, 31) qui contiennent des informations de couple pour les positions de transmission pour les zones prédéfinies parcourues, pour autoriser la suite de l'exploitation.

**4.** Procédé selon la revendication 2 ou 3,
**caractérisé en ce que**
pour la présélection, on n'autorise, pour la suite de l'exploitation que les courbes de signal (21, 22, 31) pour lesquelles l'écart du maximum global et du minimum global par rapport à la valeur moyenne de la courbe de signal ne dépasse pas un seuil prédéfini.

**5.** Procédé selon l'une des revendications 1 à 4,
**caractérisé en ce que**
à partir des courbes de signal analysées (21, 22, 31) on détermine et on élimine une partie égale.

**6.** Procédé selon la revendication 5,
**caractérisé en ce que**

- on détermine la partie égale en formant une valeur moyenne glissante (32) de la courbe de signal (21, 22) pour lisser la courbe de signal, et
- on élimine la partie égale en retranchant cette valeur moyenne glissante (32) de la valeur de mesure associée, correspondante, de la courbe de signal (21, 22, 31) non lissée.

**7.** Procédé selon la revendication 6,
**caractérisé en ce que**
en outre on effectue une division à travers la courbe de signal lissée pour corriger les amplitudes produites périodiquement et qui dépendent du couple et/ou en option, effectuer un autre lissage et/ou un filtrage avec filtre passe-bas, pour éliminer d'éventuels signaux parasites de la courbe de signal.

**8.** Procédé selon la revendication 6,
**caractérisé en ce que**
on détermine la partie commune et on l'élimine en appliquant un filtre passe-bande à la courbe de signal (21, 22, 31).

**9.** Procédé selon la revendication 8,
**caractérisé en ce que**
on sélectionne les limites supérieure et inférieure de fréquence du filtre à bande passante comme fonction de la vitesse de rotation d'entrée pour que la fréquence d'engrènement de la composante à surveiller de la transmission (3) représente la partie principale des variations périodiques du signal.

**10.** Procédé selon l'une des revendications 5 à 9,
**caractérisé en ce que**
on normalise la courbe de signal (21, 22, 31) avec la partie commune déterminée.

**11.** Procédé selon l'une des revendications 1 à 10,
**caractérisé en ce que**
on enregistre l'histogramme (50, 51) comme un tableau de nombres qui enregistre pour chaque zone de la grandeur en corrélation avec la position de la transmission (3), le nombre $n_i$ des courbes de signal (21, 22, 31) dont l'analyse a associé l'élément caractéristique d'un dommage de transmission à cette zone ainsi que le nombre de dépassements $r_i$ de cette plage angulaire.

**12.** Procédé selon la revendication 11,
**caractérisé en ce que**

on actualise le tableau de nombres au moins une fois avec des valeurs corrigées $n_{i-neu}$ et $r_{i-neu}$ selon la règle suivante :

1.

$$n_{i-neu} = n_i - \bar{n} \cdot r_i / r_{sup}$$

2.

$$r_{i-neu} = r_i - c$$

dans laquelle

$\bar{n}$ représente la valeur moyenne de toutes les entrées $n_i$,
$r_{sup}$ désigne le nombre maximum de dépassements dans l'ensemble du réseau,

- éventuellement on met pour des valeurs négatives $n_{i-neu}$ produites, à une valeur positive constante,
- on élimine d'éventuels chiffres après la virgule, et

$c$ est une valeur constante notamment, le plus petit $r_i$ du réseau de chiffres avant l'actualisation.

**13.** Procédé selon la revendication 11 ou 12,
**caractérisé en ce que**
le tableau de nombres est exploité avec une comparaison de seuil.

**14.** Procédé selon la revendication 13,
**caractérisé en ce que**

la comparaison de seuil se fait selon la formule suivante :

$$X = \frac{n_{max}}{\frac{1}{j-1}\left[\sum_i n_i - n_{max}\right]} \quad \rightarrow \quad \begin{cases} \text{Transmission en ordre} & \text{si } X < T_{rel} \\ \text{Transmission défaillante} & \text{si } X \geq T_{rel} \end{cases}$$

relation dans laquelle

X est la valeur présente calculée,

$T_{rel}$ est le seuil à partir duquel il y a émission d'un avertissement de dommage de transmission,

$n_{max}$ est le nombre maximum d'événements de dommages dans le réseau de chiffres,

$r_{max}$ est le nombre correspondant de dépassements,

$n_i$ est l'entrée d'ordre i d'événements de dommages dans le réseau de chiffres,

$r_i$ est le nombre respectivement correspondant de dépassements, et

j est le nombre total de plages angulaires.

**15.** Procédé selon l'une des revendications 1 à 14,
**caractérisé en ce que**
lors de la vérification automatique si l'histogramme (51, 52) a une accumulation imprévisible d'enregistrements dans une classe pour de l'usure et/ou des dommages de transmission, on corrige un arrière-plan non réparti de manière aléatoire.

**16.** Procédé selon l'une des revendications 1 à 15,
**caractérisé en ce que**
on analyse séparément les courbes de signal (21, 22, 31) selon le sens de circulation.

Fig. 1

Fig. 2

Fig. 3

Fig. 4

| | |
|---|---|
| 1. | Vorauswahl |
| 2. | Entfernen Gleichanteil & Normieren |
| 3. | Zuordnung Winkel & Binning in $\alpha$ |
| 4. | Bestimmen von $\alpha_{max}$ |
| 5. | Eintragen und Hochzählen von $\alpha_{max}$ in Zahlenarray |
| 6. | Auswertung Zahlenarray & Schadensmeldung |

Fig.5

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016222660 A1
- US 4965513 A
- EP 4012426 A1
- US 8180143 B2